# EUROPEAN PATENT SPECIFICATION

(11) **EP 1 130 673 B1**
(45) Date of publication and mention of the grant of the patent: **10.12.2003**
(21) Application number: 01104937.6
(22) Date of filing: 28.02.2001
(51) Int. Cl.: H05K 9/00, H01P 1/00

(54) **High frequency component and communication apparatus incorporating the same**
Hochfrequenz-Bauelement und Kommunikationsgerät mit einem derartigen Bauelement
Composant haute-fréquence et appareil de communication le comportant

(30) Priority: 29.02.2000 JP 2000053314
(43) Date of publication of application: 05.09.2001
(60) Divisional application: 03023555.0
(73) Proprietor: Murata Manufacturing Co., Ltd., Nagaokakyo-shi Kyoto-fu 617-8555 (JP)
(72) Inventor: Ito, Tomonori, (A170) Intellectual Propt. Dept., Nagaokakyo-shi, Kyoto-fu 617-8555 (JP); Yoshida, Norio, (A170) Intellectual Propt. Dept., Nagaokakyo-shi, Kyoto-fu 617-8555 (JP); Watanabe, Takahiro, (A170) Intellect. Propt. Dept., Nagaokakyo-shi, Kyoto-fu 617-8555 (JP)
(74) Representative: Schoppe, Fritz, Dipl.-Ing.

(56) References cited:
- US-A- 4 707 722
- US-A- 5 039 974
- US-A- 5 783 978

## Description

### BACKGROUND OF THE INVENTION

### 1. Field of the Invention

The present invention relates to high frequency components having metal covers attached thereto and communication apparatuses incorporating the same.

### 2. Description of the Related Art

In a conventional high frequency component such as a voltage-controlled oscillator (VCO) and a PLL module used in a mobile phone and the like, various kinds of chip components are mounted on a substrate having an electrode pattern formed thereon. In addition, a metal cover is attached to the substrate to cover the top of the substrate including the chip components.

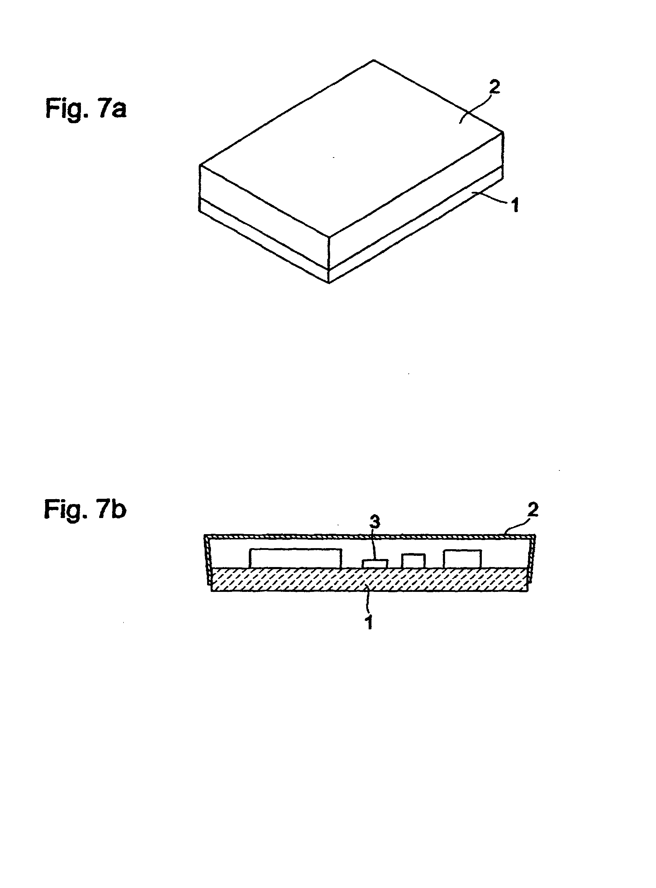

Each of Figs. 7A and 7B shows the structure of such a conventional high frequency component. Fig. 7A shows a perspective view of the high frequency component and Fig. 7B shows a sectional view thereof. In these figures, the reference numeral 1 denotes a ceramic substrate, on which various kinds of chip components including a chip coil 3 are mounted. A metal cover 2 is fitted over the top of the substrate 1 to cover the top of the substrate 1, on which the chip components are mounted.

In the conventional high frequency component in which the top of the substrate 1 having the chip components mounted thereon is covered with the metal cover 2, the metal cover 2 comes close to the components mounted on the substrate, particularly, it comes close to the chip coil 3. As a result, the inductance of the chip coil is likely to reduce. In addition, when a position for attaching the metal cover 2 to the substrate 1 changes due to positional inaccuracy for mounting the chip coil 3 on the substrate 1 and dimensional inaccuracy of the metal cover 2, the inductance of the chip coil 3 varies.

As a result, the above problems affect the characteristics of the high frequency component such as a VCO and a PLL module. The characteristics thereof deviates from a predetermined characteristic range, thereby degrading a good product ratio.

US-A-5,039,974 describes a protective cap for a rotatably-adjustable electrical component comprising a printed board with a chip mounted thereon, a housing covering the top of the printed board and a hole formed in a portion of the housing in the vicinity of the chip.

US-A-5,783,978 discloses a band-rejection filter comprising a dielectric resonator. The dielectric resonator comprises a dielectric base made of a dielectric material. A penetrating hole extends from a center of one side end of the dielectric base to a center of the other side end in a longitudinal direction of the dielectric base. An outer-conductive layer is arranged on four outer-side surfaces of the dielectric base. An inner-conductive layer is arranged on an inner-side surface of the dielectric base.

US-A-4,707,722 describes a laser-marking method and ablative coating for use therein. A steel cap is cleaned and rinsed. A nickel layer is deposited on the steel surface. The nickel layer is converted to a form which is highly absorbed of laser energy by means of an acid bath. The nickel layer is marked with a laser-marking apparatus.

### SUMMARY OF THE INVENTION

In view of the foregoing, it is an object of the present invention to provide a high frequency component capable of suppressing changes in the inductance of a chip coil mounted on a substrate to obtain stable characteristics. It is another object of the invention to provide a communication apparatus incorporating the high frequency component.

These objects are achieved by a high frequency component according to claim 1 and a communication apparatus according to claim 3.

According to a first aspect of the invention, there is provided a high frequency component including a substrate, high frequency circuit components including a chip coil mounted on the substrate, a metal cover for covering the top of the substrate, and a hole formed in a portion of the metal cover in the vicinity of the chip coil, wherein the diameter or widths of the hole are greater than the diameter or widths of the chip coil and are made equal to or less than a length corresponding to 1/4 wavelength of a used frequency.

In this arrangement, there is substantially a great distance between the chip coil and the metal cover so that coupling between the chip coil and the metal cover is weakened. This can reduce influences occurring when the metal cover is positioned close to the chip coil. In addition, this arrangement also can reduce changes in the inductance of the chip coil associated with changes in the distance between the chip coil and the metal cover.

With this arrangement, the radiation and incidence of electromagnetic waves of frequency bands equal to or higher than the used frequency band can be sufficiently suppressed. As a result, the shielding effect of the metal cover can be maintained.

In addition, in this high frequency component, an inner surface of the metal cover may be solder-plated and an outer surface thereof may be nickel-plated.

According to a second aspect of the present invention, there is provided a communication apparatus incorporating the high frequency component having the above structure. For example, the high frequency component is applied as an oscillator or a filter used for high frequency signals.

### BRIEF DESCRIPTION OF THE DRAWINGS

Figs. 1A and 1B show a perspective view and a sectional view of a high frequency component according to a first embodiment of the present invention;
Figs. 2A and 2B show top views of the high frequency component;
Fig. 3 shows a circuit diagram of the main part of the high frequency component;
Fig. 4 shows a top view of a high frequency component according to a second embodiment of the invention;
Fig. 5 shows a partial sectional view of a high frequency component according to a third embodiment of the invention;
Fig. 6 shows a block diagram of a communication apparatus according to a fourth embodiment of the invention; and
Figs. 7A and 7B show a perspective view and a sectional view for illustrating the structure of a conventional high frequency component.

### DESCRIPTION OF THE PREFERRED EMBODIMENTS

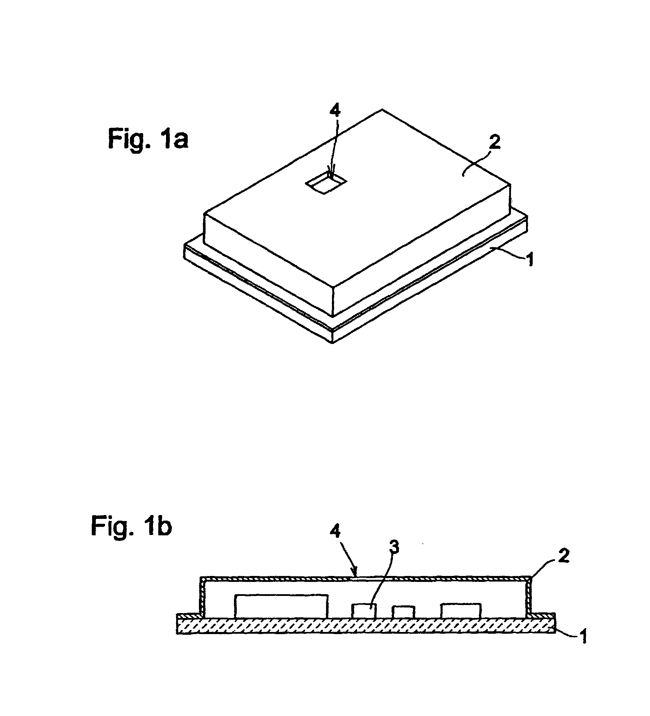

A description will be given of the structure of a PLL module as a high frequency component according to a first embodiment of the present invention with reference to Figs. 1A and 1B to Fig. 3.

Fig. 1A shows a perspective view of the PLL module, and Fig. 1B shows a sectional view thereof. In this PLL module, an electrode pattern is formed on an upper surface of a ceramic substrate 1, and predetermined chip components including a chip coil 3 are mounted thereon. In a part of a metal cover 2, a hole 4 is formed near the chip coil 3.

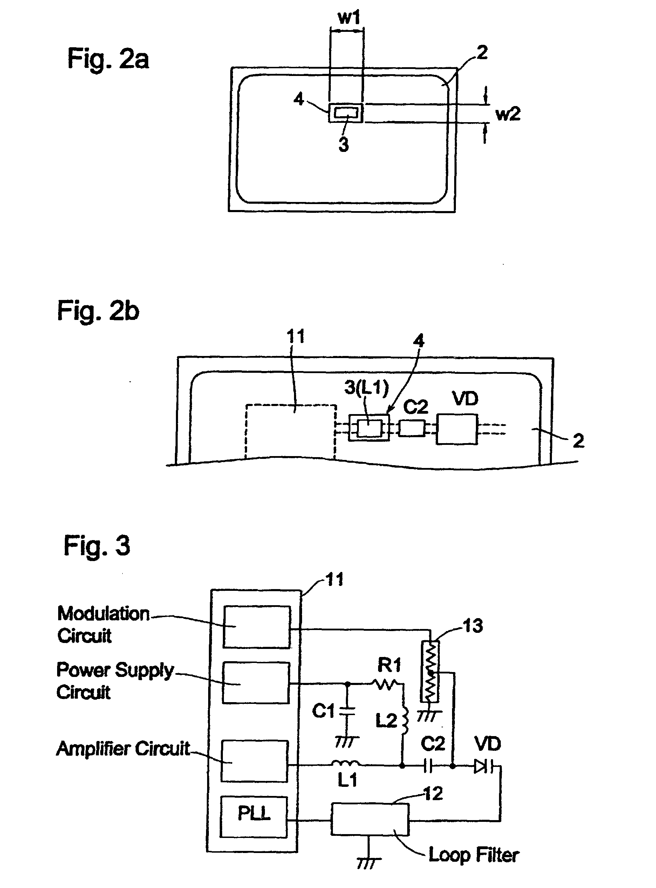

Fig. 2A shows a top view of the PLL module, and Fig. 2B shows a partially enlarged view thereof. The widths w1 and w2 of the hole 4 are made greater than the widths of the chip coil 3, and are set to be equal to or less than a length corresponding to 1/4 wavelength of a used frequency.

In these figures, the widths of the chip coil 3 are set to be 1.0 mm × 0.5 mm. The width w1 is greater than 1.0 mm, and the width w2 is greater than 0.5 mm. In addition, both w1 and w2 are made less than a length of 31 mm corresponding to 1/4 wavelength of a used frequency of 2.4 GHz.

Fig. 3 shows a circuit diagram of the main part of the above PLL module. The reference numeral 11 denotes a high frequency integrated circuit (IC). An amplifier circuit included in the high frequency IC and a resonance circuit composed of a chip inductor L1, a chip capacitor C2, and a varactor diode VD constitute a voltage-controlled oscillation circuit (VCO). A loop filter 12 is disposed at the output end of a PLL circuit included in the high frequency IC 11. The output end of the loop filter 12 is connected to the cathode of a varactor diode VD. The output end of a modulation circuit included in the high frequency IC 11 is connected to the anode of the varactor diode VD via a resistance voltage divider 13 which divides voltage by resistor. In addition, a voltage of a power supply circuit included in the high frequency IC 11 is connected to the chip inductor L1 via a capacitor C1, a resistor R1 and a choke coil L2. With this arrangement, a power supply voltage is supplied to the amplifier circuit.

The above PLL circuit performs a phase comparison between a reference frequency signal supplied from the outside and an oscillation signal of the oscillation circuit, and sends a phase error signal to the varactor diode VD via the loop filter 12. With this arrangement, the capacitance of the varactor diode VD is changed so that the oscillation frequency is controlled. Furthermore, the modulation circuit controls a voltage applied to the varactor diode VD to modulate the oscillation frequency.

The reference numerals 11, L1, C2, and the reference character VD shown in Figs. 2A and 2B correspond to the high frequency IC 11, the chip inductor L1, the chip capacitor C2, the varactor diode VD shown in Fig. 3.

As shown here, the hole 4 of the metal cover 2 is positioned near the chip coil 3 (L1). This arrangement can suppress electromagnetic coupling between the chip coil 3 and the metal cover 2. Thus, there is only a slight change in the inductance of the chip coil 3 before and after covering with the metal cover 2. As a result, before covering the top part of the substrate 1 with the metal cover 2, it is only necessary to measure and adjust the characteristics of the PLL module. In addition, the characteristics of the PLL module do not change even after covering with the metal cover 2.

Furthermore, the widths of the hole 4 formed in the metal cover 2 are greater than the chip coil 3. Thus, even if a slight deviation occurs between the position of the chip coil 3 and the position of the hole 4 of the metal cover 2, the inductance of the chip coil 3 hardly changes when the metal cover 2 comes close to the chip coil 3. Thus, regardless of the dimensional accuracy of a position for mounting the chip coil 3 on the substrate 1, the accuracy of fitting the metal cover 2 over the substrate 1, and the dimensional accuracy of the metal cover 2, the inductance of the chip coil 3 shows a predetermined value so that the PLL module can have stable characteristics.

Furthermore, the widths of the hole 4 formed in the metal cover 2 are made equal to or less than a length corresponding to 1/4 wavelength of the used frequency. Thus, the unnecessary radiation of electromagnetic waves in the used frequency band and a higher frequency band to the outside and the incidence thereof from the outside to the inside can be suppressed. As a result, the shielding effect of the metal cover 2 can be maintained.

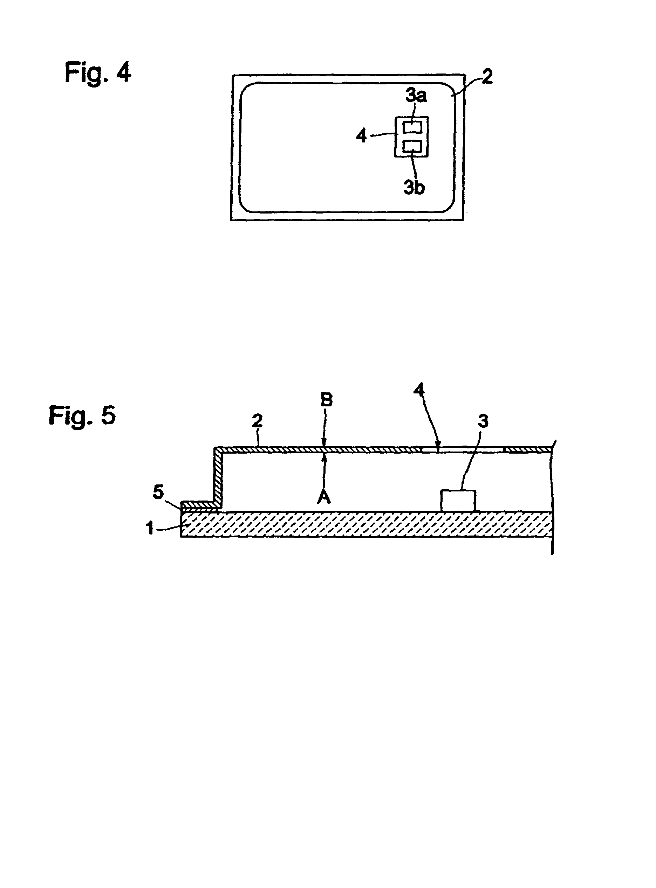

Fig. 4 shows a high frequency component according to a second embodiment of the invention. Fig. 4 shows the top view of the high frequency component. As clear from a comparison with the embodiment shown in Figs. 2A and 2B, in this embodiment, chip coils 3a and 3b are positioned close to each other on a substrate. A metal cover 2 has a hole 4 shared by the two chip coils 3a and 3b. With this arrangement, similarly, coupling between the metal cover 2 and the chip coils 3a and 3b can be suppressed. As a result, the same advantages as those in the first embodiment can be obtained. In addition, in this embodiment, since the single hole 4 is only formed in the metal cover 2, the metal cover 2 can be easily produced.

In the embodiments, the hole 4 has a rectangular shape. However, the hole 4 may be a round hole having a diameter which is greater than the widths of the chip coil 3 and is less than a length corresponding to 1/4 wavelength of a used frequency.

Next, Fig. 5 shows a partial section of a high frequency component according to a third embodiment of the present invention. In this embodiment, an inner surface A of a metal cover 2 is solder-plated, and an outer surface B thereof is nickel-plated. Such a metal cover is formed as follows. That is, there is provided a metal plate in which one surface of the metal plate is nickel-plated and the other surface thereof is solder-plated. Then, the metal plate is stamped out or compressed to form a cover.

When the metal cover 2 is attached to the top of the substrate 1, the inner surfaces of peripheral portions of the metal cover 2 are soldered with an electrode pad 5 on the substrate.

As mentioned above, when the inner surface of the metal cover 2 is solder-plated, the soldered-surface wettability can be satisfactory enough to easily maintain the strength to attach the metal cover 2 to the substrate 1. In addition, since the outer surface of the metal cover 2 is nickel-plated, the metal cover 2 becomes brighter and laser marking can also be performed.

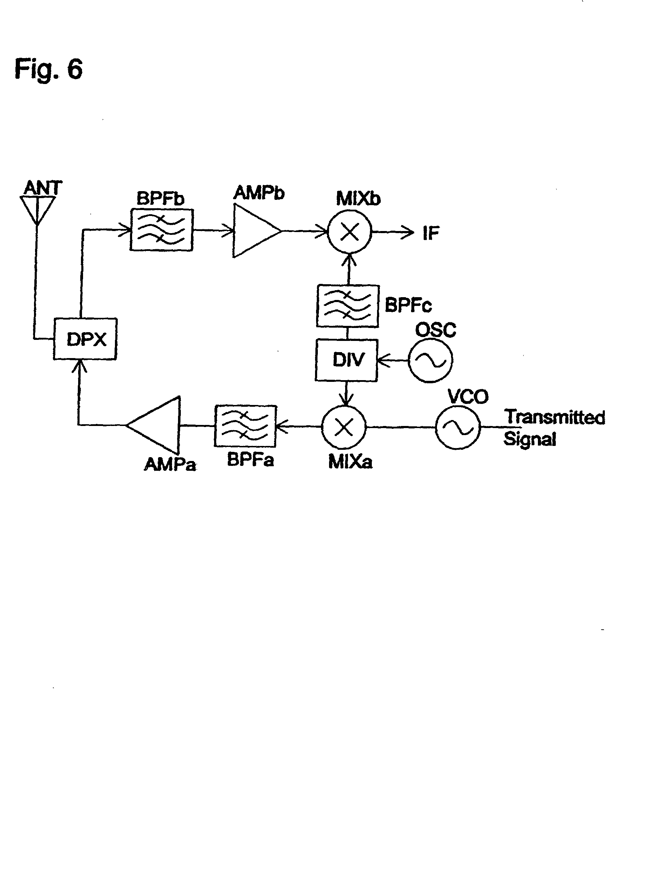

Next, a description will be given of the structure of a communication apparatus according to a fourth embodiment of the present invention with reference to Fig. 6. In this figure, the reference character ANT denotes a transmission/reception antenna, the reference character DPX denotes a duplexer, the reference characters BPFa, BPFb, and BPFc denote band pass filters, and the reference characters AMPa and AMPb denote amplifier circuits. The reference characters MIXa and MIXb denote mixers, the reference character OSC denotes an oscillator, and the reference character DIV denotes a frequency divider (synthesizer). The reference character VCO denotes a voltage-controlled oscillator modulating an oscillation frequency with a signal according to transmitted signal (transmitted data).

The MIXa modulates a frequency signal output from the DIV with a modulation signal. The BPFa passes only signals of a transmitted frequency band, and the AMPa performs power-amplification of the signals to transmit from the ANT via the DPX. The BPFb passes only signals of a received frequency band among signals output from the DPX, and the AMPb amplifies the signals. The MIXb mixes a frequency signal output from the BPFc and a received signal to output an intermediate frequency signal IF.

The high frequency components shown in Figs. 1A and 1B to 5 are used as a high frequency component using a chip coil, such as the VCO and the filters shown in Fig. 6. As a result, there can be provided a communication apparatus incorporating the high frequency component having stable characteristics.

As described above, according to the first aspect of the invention, the chip coil is unlikely to be influenced by the metal cover positioned close to the chip coil. Thus, the chip coil can be used as a device having a proper inductance. Furthermore, changes in the inductance of the chip coil with respect to changes in the distance between the chip coil and the metal cover are reduced.

In addition, the radiation and incidence of electromagnetic waves in a frequency band equal to or higher than a used frequency band through the hole formed in the metal cover can be sufficiently suppressed. As a result, stable operations can be performed.

In addition, the strength to attach the metal cover to the electrode pad on the substrate can be sufficiently increased. Furthermore, the appearance of the high frequency component can be made better. Additionally, with laser marking, the product number and like can be easily entered on the metal cover.

According to the second aspect of the invention, the high frequency component having predetermined characteristics and operating in a stable manner is used to form the high frequency circuit section including the filter, the oscillator, and the like, applied for high frequency signals. Thus, the communication apparatus having predetermined communication capabilities can be easily constituted.

## Claims

1. A high frequency component comprising:
a substrate (1);
high frequency circuit components including a chip coil (3) mounted on the substrate (1);
a metal cover (2) for covering the top of the substrate (1); and
a hole (4) formed in a portion of the metal cover (2) in the vicinity of the chip coil (3; 3a, 3b)
wherein the diameter or widths (w₁, w₂) of the hole (4) are greater than the diameter or widths of the chip coil (3; 3a, 3b), and are made equal to or less than a length corresponding to 1/4 wavelength of a used frequency.

2. A high frequency component according to Claim 1, wherein an inner surface of the metal cover (2) is solder-plated and an outer surface thereof is nickel-plated.

3. A communication apparatus comprising the high frequency component according to Claim 1 or 2.

## Patentansprüche

1. Eine Hochfrequenzkomponente, die folgende Merkmale aufweist:
ein Substrat (1);
Hochfrequenzschaltungskomponenten, die eine an dem Substrat (1) angebrachte Chipspule (3) umfassen;
eine Metallabdeckung (2) zum Abdecken der Oberseite des Substrats (1); und
ein Loch (4), das in einem Abschnitt der Metallabdekkung (2) in der Nähe der Chipspule (3; 3a, 3b) gebildet ist,
wobei der Durchmesser oder die Breiten (w₁, w₂) des Loches (4) größer sind als der Durchmesser oder die Breiten der Chipspule (3; 3a, 3b) und gleich einer oder geringer als eine Länge hergestellt sind, die 1/4 einer Wellenlänge einer verwendeten Frequenz entspricht.

2. Eine Hochfrequenzkomponente gemäß Anspruch 1, bei der eine Innenoberfläche der Metallabdeckung (2) lötplattiert ist und bei der eine Außenoberfläche derselben nickelplattiert ist.

3. Eine Kommunikationsvorrichtung, die die Hochfrequenzkomponente gemäß Anspruch 1 oder 2 aufweist.

## Revendications

1. Composant haute fréquence comprenant:
Un substrat (1);
des composants d'un circuit haute fréquence
comprenant un enroulement ultra-mince (3) monté sur le substrat (1);
un capot métallique (2) recouvrant le sommet du substrat (1); et
un trou (4) pratiqué dans une partie du capot métallique (2) à proximité de l'enroulement ultra-mince (3; 3a, 3b)
dans lequel le diamètre ou les largeurs (w₁, w₂) du trou (4) sont supérieurs au diamètre ou largeurs de l'enroulement ultra-mince (3; 3a, 3b), et sont rendus égaux à ou inférieurs à une longueur correspondant à 1/4 longueur d'onde d'une fréquence utilisée.

2. Composant haute fréquence selon la revendication 1, dans lequel une surface inférieure du capot métallique (2) est revêtue de soudure et une surface extérieure de celui-ci est nickelée.

3. Appareil de communication comprenant le composant haute fréquence selon la revendication 1 ou 2.
